Europäisches Patentamt

European Patent Office

Office européen des brevets

(19)

(11) **EP 1 370 619 B1**

(12) **EUROPÄISCHE PATENTSCHRIFT**

(45) Veröffentlichungstag und Bekanntmachung des Hinweises auf die Patenterteilung:
**21.06.2006 Patentblatt 2006/25**

(21) Anmeldenummer: **02703624.3**

(22) Anmeldetag: **07.03.2002**

(51) Int Cl.:
*C09D 11/00* (2006.01)    *C09K 11/06* (2006.01)
*H01L 51/40* (2006.01)

(86) Internationale Anmeldenummer:
**PCT/EP2002/002491**

(87) Internationale Veröffentlichungsnummer:
**WO 2002/072714 (19.09.2002 Gazette 2002/38)**

(54) **LÖSUNG UND DISPERSIONEN ORGANISCHER HALBLEITER**

SOLUTIONS AND DISPERSIONS OF ORGANIC SEMICONDUCTORS

SOLUTIONS ET DISPERSIONS DE SEMI-CONDUCTEURS ORGANIQUES

(84) Benannte Vertragsstaaten:
**DE FR GB IE NL**

(30) Priorität: **10.03.2001 DE 10111633**

(43) Veröffentlichungstag der Anmeldung:
**17.12.2003 Patentblatt 2003/51**

(73) Patentinhaber: **Merck Patent GmbH**
**64293 Darmstadt (DE)**

(72) Erfinder:
• **SPREITZER, Hubert**
**68519 Viernheim (DE)**
• **BECKER, Heinrich**
**61479 Glashütten (DE)**
• **TREACHER, Kevin**
**65779 Kelkheim/Münster (DE)**
• **HEUN, Susanne**
**65812 Bad Soden (DE)**
• **SAUER, Andreas**
**60529 Frankfurt (DE)**

(74) Vertreter: **Benz, Jürgen et al**
**Merck Patent GmbH**
**Frankfurter Strasse 250**
**64293 Darmstadt (DE)**

(56) Entgegenhaltungen:
**EP-A- 0 779 348**      **WO-A-00/59267**
**WO-A-01/47045**

• **HEBNER T R ET AL: "INK-JET PRINTING OF DOPED POLYMERS FOR ORGANIC LIGHT EMITTING DEVICES" APPLIED PHYSICS LETTERS, AMERICAN INSTITUTE OF PHYSICS. NEW YORK, US, Bd. 72, Nr. 5, 2. Februar 1998 (1998-02-02), Seiten 519-521, XP000737411 ISSN: 0003-6951**
• **H. ANTONIADIS ET AL.: "Light-emitting diodes based on Poly(2,3-diphenyl-1,4-phenylene vinylene)" POLYMERS FOR ADVANCED TECHNOLOGIES, Bd. 8, Nr. 7, 1997, Seiten 392-398, XP002205971**

EP 1 370 619 B1

**Beschreibung**

Die vorliegende Erfindung betrifft Lösungen und/oder Dispersionen organischer Halbleiter sowie deren Verwendung in der Elektronikindustrie

In einer Reihe von verschiedenartigen Anwendungen, die im weitesten Sinne der Elektronikindustrie zugerechnet werden können, ist der Einsatz organischer Halbleiter als Wirkkomponenten (= Funktionsmaterialien) seit geraumer Zeit Realität bzw. wird in naher Zukunft erwartet.

So finden schon seit etlichen Jahren Ladungstransportmaterialien auf organischer Basis (i. d. R. Lochtransporter auf Triarylaminbasis) Verwendung in Kopiergeräten. Die Verwendung spezieller halbleitender organischer Verbindungen, die zum Teil auch zur Emission von Licht im sichtbaren Spektralbereich befähigt sind, steht gerade am Anfang der Markteinführung, zum Beispiel in Organischen bzw. Polymeren Elektrolumineszenz-Vorrichtungen.

Die Verwendung organischer Ladungstransportschichten in Anwendungen wie Organischen-Integrierten-Schaltungen (Organischen ICs) und Organischen-Solarzellen ist zumindest im Forschungsstadium schon sehr weit gediehen, so daß eine Markteinführung innerhalb der nächsten Jahre erwartet werden kann.

Die Anzahl weiterer Möglichkeiten ist sehr groß, häufig jedoch nur als Abwandlung der oben aufgeführten Prozesse zu sehen, wie die Beispiele Organische-Feststofflaserdioden und Organische-Photodetektoren belegen.

Bei einigen dieser modemen Anwendungen ist die Entwicklung teilweise bereits sehr weit fortgeschritten, dennoch besteht - je nach Applikation - immer noch ein immenser Bedarf an technischen Verbesserungen.

Bei den Organischen-Elektrolumineszenz-Vorrichtungen bzw. deren Einzelbauteilen, den Organischen-Lichtemittierenden-Dioden (OLEDs) ist die Markteinführung bereits erfolgt, wie die im Markt erhältlichen Auto-Radios mit "Organischem Display" der Firma Pioneer belegen. Auch bei der hochmolekularen Variante (den Polymeren Lichtemittierenden Dioden, PLED) ist eine Markteinführung in nächster Zeit zu erwarten. Trotz allem sind hier noch deutliche Verbesserungen nötig, um diese Displays zu einer echten Konkurrenz zu den derzeit marktbeherrschenden Flüssigkristallanzeigen (LCD) zu machen bzw. diese zu überflügeln.

Der allgemeine Aufbau solcher PLEDs ist in WO 90/13148 wiedergegeben.

Weitere Ausgestaltungsformen solcher PLEDs wie Passiv-Matrix-Adressierung, Aktiv-Matrix-Adressierung sind in den weiter unten genannten Literaturstellen erläutert.

Für die PLEDs zeichnet sich die Entwicklung von vollfarbigen Anzeigevorrichtung ab. Um zu einer solchen vollfarbigen Anzeigevorrichtung zu kommen, ist es nötig, Beschichtungsverfahren zu entwickeln, die es erlauben, die drei Grundfarben (rot, grün, blau, RGB) räumlich getrennt aufzubringen. Da die Polymere aus Lösung und/oder Dispersion aufgebracht werden, sind hierbei Druckverfahren die Möglichkeit der Wahl.

Derzeit wird wegen der guten Steuerbarkeit, der erreichbaren Auflösung und der großen Variabilität, hauptsächlich an Tintenstrahldruck-Verfahren (ink-jet printing, IJP) gearbeitet. Grundsätzlich eignen sich aber auch andere Druckverfahren, wie z.B. Offsetdruck, Transferdruck, oder Tiefdruckverfahren.

Das Tintenstrahldruck-Verfahren zur Herstellung von PLEDs und entsprechenden Displays ist bereits mehrfach im Stand der Technik beschrieben.

Dieser nächstliegende Stand der Technik wird im folgenden beschrieben:

Aus EP-A-0880303 ist das Prinzip und die Verwendung von IJP zur Herstellung von PLEDs erstmals beschrieben. Gemäß EP-A-0880303 wird eine Lösung eines "organischen Lumineszenzmaterials" bzw. eine Lösung eines entsprechenden Precursors durch IJP auf ein photolithographisch vorbereitetes Substrat, welches Partitionierungen und Anode enthält, aufgebracht.

Durch die Verwendung verschiedenartiger Lösungen können so verschiedenfarbige Pixel erzeugt werden. In dieser Anmeldung wird mehr das Prinzip, weniger aber die technische Lehre, welche die praktische Durchführung und die dabei zu lösenden Probleme aufzeigt, gelehrt.

So gibt EP-A-0880303 - bis auf drei eher aufgabenhafte Formulierungen - keine Lehre über die Konsistenz und die Darstellung der entsprechenden Lösungen. Es wird nur formuliert, die Lösungen müßten einen Kontaktwinkel zwischen 30 und 170 Grad gegenüber dem Material der Düsen-Platte (nozzle plate) des IJ-Druckkopfs haben, damit die Lösung vernünftig gedruckt werden könne. Des weiteren sollte die Viskosität der Lösung zwischen 1 und 20 mPa·s (cps) liegen, damit zum einen die Konzentration an Wirkstoff hoch genug ist, zum anderen die Lösung auch noch mittels IJP druckbar ist. Schließlich soll die Oberflächenspannung der Lösung im Bereich zwischen 20 und 70 dyne/cm liegen.

Diese Angaben stellen allerdings technisch keine relevante Einschränkung bzw. Hilfestellung oder Lehre zum technischen Handeln dar, da der breite Kontaktwinkel praktisch für fast alle Lösungen oder Lösemittel Anwendung finden kann, wenn nur die Düsen-Platte entsprechend präpariert wird. Ebenso beginnt der angegebene Viskositätsbereich bereits bei nahezu purem Lösemittel (zum Vergleich: reines Toluol hat ca. 0.6 mPa·s; Tetralin hingegen bereits ca. 2 mPa.s) und geht- je nach Molekulargewicht der eingesetzten organischen Verbindung - bis hin zu sehr hohen Konzentrationen.

Schließlich gibt auch der angegebene Oberflächenspannungsbereich keine echte Information bzw. Einschränkung; die meisten verwendbaren organischen Lösemittel haben Werte im angegebenen Bereich; durch Auflösen von Polymeren verändern sich diese Werte nicht wesentlich.

In WO 99/39373 findet sich - in praktischer Hinsicht - nur die Lehre zum IJP von mit Farbstoffen dotierten Polyvinylcarbazol (PVK) Lösungen. Diese Chloroform-haltigen-Lösungen führen laut Anmeldung zu starken (nicht behobenen) Problemen in der Anwendung (OLED): (i) die Pixel sind inhomogen, es könnte auf eine Teilentmischung des Farbstoffs und des Polymers geschlossen werden; (ii) die Device-Effizienz ist ca. 50% schlechter, als die einer ohne IJP hergestellten Leuchtdiode. Die ungünstigen anwendungstechnischen Eigenschaften von Chloroform (Toxizität etc.) sind hinreichend bekannt.

In WO 00/59267 werden erstmalig die verschiedenen Probleme von Lösungen für die Herstellung organischer Filme oder Punkte durch IJP aufgezeigt.

So beschreibt WO 00/59267 zumindest zwei wesentliche Probleme:

Problem 1: Lösemittel mit zu hohem Dampfdruck, d.h. mit einem zu niedrigem Siedepunkt, führen dazu, daß die IJ-Lösungen im Druckkopf bzw. an der Düse bzw. an der Düsenplatte eintrocknen. Dies hat zur Folge, daß die Düse verstopfen kann und der Druckprozeß schlecht reproduzierbar wird. Ein solches System ist für eine industrielle Fertigung ungeeignet.

Problem 2: Enthält die IJ-Lösung verschiedene Materialien (Blends), kann es beim Eintrocknen der IJ-Lösung dazu kommen, daß zunächst eine dieser Substanzen ausfällt. Dies führt zu einer inhomogenen Verteilung der verschiedenen Materialien im gebildeten Pixel. Derartig inhomogene Pixel zeigen im OLED Device eine deutliche Verschlechterung der Device-Eigenschaften.

Zur Lösung des vorstehenden Problem 1 wird in WO 00/59267 vorgeschlagen Lösemittel mit speziellen Eigenschaftsprofilen zu verwenden. Als geeignete Lösemittel werden substituierte Benzolderivate, die mindestens 3 C-Atome im Substituenten bzw. in den Substituenten aufweisen, vorgeschlagen. Dabei werden solche Lösemittel, deren Siedepunkt bei mindestens 200°C liegt, bevorzugt. Das als besonders bevorzugt gelehrte Lösemittel Dodecylbenzol hat jedoch einen Siedepunkt von ca. 300°C.

Als weitere Möglichkeit zur Lösung des Problem 1 wird in WO 00/59267 vorgeschlagen eine Mischung von mindestens zwei Lösemitteln, wobei das erste die oben genannten Eigenschaften aufweist und das zweite auch einen niedrigeren Siedepunkt aufweisen kann, dieser aber wiederum mindestens 140°C beträgt, wobei hier die Darstellung unklar ist, da bei diesen Zumisch-Lösemitteln auch solche genannt werden, die einen deutlich niedrigeren Siedepunkt aufweisen, wie z. B. Toluol (Sdp. ~111 °C), Chloroform (Sdp. -61 °C) und Tetrachlorkohlenstoff (Sdp. 76°C). Diese Lösungen enthaltend die oben genannten Lösemittel bzw. Lösemittelgemische sollen nun folgende Problemlösungen bringen:

Zunächst verhindert das hochsiedende Lösemittel die Eintrocknung der Lösung im Druckkopf (Lösung des Problems 1). Zur Homogenisierung des Pixels (Lösung des Problems 2) und vor allem um das schwer zu entfernende hochsiedende Lösemittel zu entfernen, wird dann eine Nachbehandlung vorgeschlagen. Bei dieser Nachbehandlung wird des Substrat, respektive der Pixel, auf Temperaturen zwischen 40 und 200°C erhitzt. Dies geschieht zunächst unter einem Überdruck von 2 bis 100 bar, um wieder eine homogene Lösung zu erzeugen. Anschließend wird unter Unterdruck weiter getempert bis alles Lösemittel entfernt ist.

Der Lösungsvorschlag gemäß der hier zitierten Anmeldung WO 00/59267 weist gravierende technische Probleme auf:

A. Aus Beispiel 1 in der hier vorliegenden Anmeldeschrift ist ersichtlich, daß die möglichst vollständige Entfernung des Lösemittels aus der Beschichtung essentiell für gute Device-Eigenschaften ist. Diese vollständige Entfernung ist gerade bei den bevorzugten hochsiedenden Lösemitteln (mit Siedepunkt über 200°C bzw. Dodecylbenzol) in einem technischen Prozeß sehr aufwendig.

B. Es wird keine technische Lehre bzw. Maßnahme offenbart, warum bei dem geschilderten Verfahren beim finalen Lösemittel-Abdampfprozeß, nicht trotzdem wiederum eine Phasen-Separation, d. h. die Bildung inhomogener Pixel eintreten soll. Das zwischenzeitliche Re-Homogenisieren könnte schließlich auch hier wieder zunichte gemacht werden.

C. Die geschilderte Maßnahmen zur Homogenisierung (HOCHDRUCK, TEMPERN, VAKUUM) ist für eine technische Massenfertigung kaum geeignet.

D. Etliche der in der Anmeldung aufgeführten Lösemittel weisen per se Probleme auf. So ist (i) die technische Verfügbarkeit von Lösemitteln wie Dodecylbenzol, Cyclohexylbenzol und anderen hochsubstituierten Benzolen nicht gegeben; (ii) einige der genannten Lösemittel weisen durch das Vorhandensein stark aktivierter benzylischer Protonen (z. B. bei Cumol, Tetralin, Dodecylbenzol, vgl. auch Beispiel 2 der vorliegenden Anmeldeschrift) ungewollte Reaktivitäten auf, die für eine technische Anwendung nachteilig sind; (iii) sind einige der genannten Zumisch-Lösemittel (z. B. Chloroform, Tetrachlorkohlenstoff) stark giftig bzw. stehen sogar unter dem Verdacht cancerogene Eigenschaften zu besitzen.

Bei der technischen Realisierung treten zusätzlich zu den in WO00/59267 bereits aufgezeigten Problemen 1 und 2 weitere Probleme auf:

Problem 3: Beim Eintrocknen der einzelnen Tropfen der IJ-Lösungen auf dem Substrat kann es dazu kommen, daß zwar die Festsubstanz homogen im Pixel verteilt ist, jedoch die Schichtdicke des gebildeten Pixels stark variiert. In der Regel sind die Ränder des Pixels deutlich höher/niedriger als die Mitte des Pixels.
Dies führt nun in der Anwendung, der PLED, dazu, daß es zu einer inhomogenen Leuchtintensität innerhalb des Pixels kommt und auch die verschiedenen Bereiche des Pixels unterschiedlich schnell degradieren.

Problem 4: Trocknet die Lösung in aufgedruckten Pixeln zu langsam ein, kann es beim Bewegen des Substrats - bei technischen IJPs wird das Substrat in der Regel in einer Richtung gefördert - der Druckkopf bewegt sich vertikal dazu kommen, daß Lösung über die Pixelbegrenzung (i. d. R. werden die Pixel durch photolitographisch erzeugte Wände begrenzt) fließt. Es gibt auch IJP-Verfahren, bei denen sich das Substrat in beiden Richtungen bewegt, und der Druckkopf stillsteht. Hier ist dieser Effekt noch drastischer.
Eine Mischung der Tinten ist insbesondere dann besonders schädlich, wenn sich dadurch verschiedenfarbige Pixellösungen mischen.
Grundsätzlich führen die nicht erwünschten Schichtdickenvariationen und daraus resultierenden Inhomogenitäten zu nicht reproduzierbaren Emissionsverhalten.

Problem 5: Wie zuvor geschildert, ist es notwendig das Lösemittel möglichst vollständig aus dem abgeschiedenen Film zu entfemen, um optimale Device-Eigenschaften zu erhalten. Hat das Lösemittel einen zu niedrigen Dampfdruck (zu hohen Siedepunkt), so ergibt dies deutliche Probleme.

All diese Probleme (1 bis 5) sind bis dato nicht zufriedenstellend gelöst.

Es ist daher Aufgabe der vorliegenden Erfindung, für die oben beschriebenen Probleme eine technische Verbesserung anzubieten.

Gegenstand der Erfindung sind Lösungen und/oder Dispersionen organischer Halbleiter, insbesondere polymerer organischer Halbleiter, in einem Lösemittelgemisch von mindestens 2 verschiedenen organischen Lösemittel, gekennzeichnet dadurch, daß

(1) Jedes der Lösemittel für sich allein genommen einen Siedepunkt von weniger als 200°C aufweist und einen Schmelzpunkt von 15°C oder niedriger aufweist,
(2) mindestens eines der Lösemittel einen Siedepunkt zwischen mehr als 140 und weniger als 200°C aufweist
(3) die eingesetzten Lösemittel keine benzylischen $CH_2$- oder CH-Gruppen aufweisen,
(4) die eingesetzten Lösemittel keine Benzolderivate sind, die tert-Butylsubstituenten oder mehr als zwei Methylsubstituenten enthalten.

Ein weiterer Erfindungsgegenstand ist die Verwendung der erfindungsgemäßen Lösungen und/oder Dispersionen, um Schichten der organischen Halbleiter, insbesondere polymere organische Halbleiter, auf einem Substrat zu erzeugen.

Eine bevorzugte Ausführungsform ist dabei die Verwendung von Druckverfahren zur Herstellung der organischen Halbleiterschichten. Besonders bevorzugt ist dabei die Verwendung von Tintensirahl-Druckverfahren (IJP).

Noch ein weiterer Erfindungsgegenstand sind die Schichten der organischen Halbleiter hergestellt unter Verwendung der erfindungsgemäßen Lösungen und Dispersionen.

Schichten der an sich bekannten organischen Halbleiter sind in der Literatur bereits beschrieben. Die mittels der erfindungsgemäßen Lösung bzw. Dispersionen hergestellten Schichten zeigen gegenüber den bislang beschriebenen verbesserte morphologische Eigenschaften. Insbesondere wird die Homogenität der Schicht, unter anderem bei der Verwendung von Blends bzw. Mischungen organischer Halbleiter, die Konstanz der Schichtdicke über die Beschichtungsfläche (z. B. das einzelne Pixel) und die Freiheit von sogenannten pin-holes (mikroskopisch kleine Löcher in der Halbleiterschicht, welche aber zu fatalen Device-Schäden führen können) durch die verbesserten Anwendungseigenschaften der erfindungsgemäßen Lösungen und Dispersionen deutlich verbessert.

Lösungen sind im Sinne dieses Anmeldungstextes Mischungen von Festsubstanzen in Lösemitteln, welche flüssig sind und in denen die Feststoffe molekular gelöst vorliegen, d. h. die große Mehrzahl der Feststoffmoleküle liegt tatsächlich gelöst und nicht in Form von Aggregaten bzw. Nano- oder Mikropartikel vor.

Dispersion sind im Sinne dieses Anmeldungstextes Mischungen von Festsubstanzen in Lösemitteln, welche flüssig sind und in denen die Feststoffe nicht molekular gelöst vorliegen, d. h. die große Mehrzahl der Feststoffmoleküle liegt nicht gelöst sondern in Form von Aggregaten bzw. Nano- oder Mikropartikeln vor.

Die Viskosität der erfindungsgemäßen Lösungen und/oder Dispersionen ist variabel. Allerdings verlangen gewisse Beschichtungstechniken eine Verwendung gewisser Viskositätsbereiche. So ist für die Beschichtung via IJP ein Bereich von ca. 4 bis 25 mPa*s als sinnvoll anzugeben. Für andere Druckverfahren, z. B. Tiefdruckverfahren, kann aber auch eine deutlich höhere Viskosität, beispielsweise im Bereich von 20 bis 500 mPa*s, durchaus Vorteile ergeben.

Organische Halbleiter im Sinne dieses Textes sind organische oder auch metallorganische Verbindungen, die - als Feststoff bzw. als konkrete Schicht - halbleitende Eigenschaften aufweisen, d. h. bei denen die Energielücke zwischen Leitungs- und Valenzband zwischen 0.1 und 4 eV liegt.

Die in den erfindungsgemäßen Lösungen und/oder Dispersionen eingesetzten organischen Halbleiter unterliegen keiner Einschränkung. Erfindungsgemäß können sowohl niedermolekulare organische Halbleiter als auch polymere Halbleiter eingesetzt werden.

Beispiele für die in den erfindungsgemäßen Lösungen und/oder Dispersionen eingesetzten organischen Halbleiter sind niedermolekulare organische Halbleiter auf Basis von Triarylaminen (Proc. SPIE-Int. Soc. Opt. Eng. 1997, 3148, 306-312), Aluminium-tris-(8-hydroxy-chinolin) (Appl. Phys. Lett. 2000, 76(1), 115-117), Pentacene (Science 2000, 287(5455), 1022-1023), Oligomere (Opt. Mater. 1999, 12(2/3), 301-305), weitere kondensierte aromatische Systeme (Mater. Res. Soc. Symp. Proc. 2000, 598, BB9.5/1-BB9.5/6) und weitere Verbindungen, wie sie beispielsweise in *J. Mater. Chem.* **2000**, 10(7), 1471-1507 und Handb. Adv. Electron. Photonic Mater. Devices **2001,** 10, 1-51 beschrieben sind. Die in den vorstehend genannten Stellen offenbarten niedermolekularen Halbleiter sind durch Zitat Bestandteil der vorliegenden Beschreibung.

Bevorzugt werden in den erfindungsgemäßen Lösungen oder Dispersionen jedoch polymere organische oder metallorganische Halbleiter verwendet.

Ganz besonders bevorzugt sind erfindungsgemäße Lösungen polymerer organischer Halbleiter.

Als polymere organische Halbleiter im Sinne der vorliegenden Beschreibung werden insbesondere (i) die in EP-A-0443861, WO 94/20589, WO 98/27136, EP-A-1025183, WO 99/24526, DE-A-19953806 und EP-A-0964045 offenbarten in organischen Lösemittels löslichen, substituierten Poly-p-arylene-vinylene (PAVs), (ii) die in EP-A-0842208, WO 00/22027, WO 00/22026, DE-A-19981010, WO 00/46321, WO 99/54385, WO 00/55927 offenbarten in organischen Lösemittels löslichen, substituierten Polyfluorene (PFs), (iii) die in EP-A-0707020, WO 96/17036, WO 97/20877, WO 97/31048, WO 97/39045 offenbarten in organischen Lösemittels löslichen, substituierten Poly-spirobifluorene (PSFs), (iv) die in WO 92/18552, WO 95/07955, EP-A-0690086, EP-A-0699699 offenbarten in organischen Lösemittels löslichen, substituierten Poly-paraphenylene (PPPs), (v) die in EP-A-1028136, WO 95/05937 offenbarten in organischen Lösemittels löslichen, substituierten Polythiophene (PTs), (vi) die in T. Yamamoto et al., *J. Am. Chem.* Soc. **1994,** *116*, 4832 offenbarten in organischen Lösemittels löslichen Polypyridine (PPys), (vii) die in V. Gelling et al., *Polym. Prepr.* **2000,** *41,* 1770 offenbarten in organischen Lösemittels löslichen Polypyrrole, (viii) substitierte, lösliche Copolymere, die Struktureinheiten von zwei oder mehr der. Klassen (i) bis (vii) aufweisen, (ix) die in *Proc. of ICSM '98*, **Part I & II** (in: *Synth. Met.* 1999, *101 + 102)* offenbarten in organischen Lösemittels löslichen konjugierten Polymeren, (x) substituierte und unsubstituierte Poly-vinyl-carbazole (PVKs), wie beispielsweise in R. C. Penwell et al., *J. Polym. Sci., Macromol. Rev.* **1978**, *13*, 63-160 offenbart und (xi) substituierte und unsubstuierte Triarylaminpolymere, wie beispielsweise in JP 2000-072722 offenbart, verstanden. Diese polymeren organischen Halbleiter sind durch Zitat Bestandteil der vorliegenden Erfindung.

Die erfindungsgemäß eingesetzten polymeren organischen Halbleiter können auch gedoped und/oder als Blend untereinander eingesetzt werden.

Die erfindungsgemäßen Lösungen und Dispersionen enthalten zwischen 0.01 und 20 Gew%, bevorzugt zwischen 0.1 und 15 Gew%, besonders bevorzugt zwischen 0.25 und 10 Gew%, ganz besonders bevorzugt zwischen 0.25 und 5 Gew% des organischen Halbleiters. Dabei ist es auch erfindungsgemäß eine Mischung / Blend aus mehr als einem organischen Halbleiter einzusetzen.

Die erfindungsgemäßen Lösungen und Dispersionen enthalten darüber hinaus - wie oben beschrieben - mindestens zwei verschiedene Lösemittel, von denen mindestens eines einen Siedepunkt über 140 und unter 200°C besitzt. Hierbei ist es bevorzugt, wenn diese Lösemittel unterschiedliche Siedepunkte aufweisen, besonders bevorzugt ist der Unterschied der Siedepunkte mehr als 10°C, ganz besonders bevorzugt beträgt diese Differenz mehr als 20°C. Das Verhältnis der beiden Lösemittel zueinander ist in weiten Bereichen variierbar. Um aber deutliche Effekte zu erzielen, sollte sich das (Volumen)verhältnis der beiden verwendeten Lösemittel im Bereich von 1:99 bis 99:1, bevorzugt im Bereich von 10:90 bis 90:10, besonders bevorzugt im Bereich von 20:80 bis 80:20 bewegen.

Diese Mischungen zeigen überraschende Verbesserungen zu den oben genannten Problemfeldern.

So führt der Anteil an Lösemittel mit Siedepunkt über 140 und unter 200°C dazu, daß (Problem 1) die Lösungen / Dispersionen im Druckkopf / an den Düsen nicht zu schnell eintrocknen. Zwar sind hier noch höher siedende Lösemittel noch besser, diese weisen dann aber besonders bei den Problemen 3 bis 5 überproportional starke Nachteile auf. Es hat sich hier als deutliche Verbesserung erwiesen, Lösemittel mit diesem Siedepunktsbereich einzusetzen:

A. Für das Problem 3 ist es deutlich besser, niedriger siedende Lösemittel zu haben, denn ein schnelleres Eindampfen führt schneller zu einer hohen Viskosität im Pixel, damit treten derartige Effekte erst gar nicht auf. Dies wird besonders durch Lösemittelgemische mit unterschiedlich siedenden Lösemitteln gefördert, da dann das niedriger siedende Lösemittel noch schneller abdampft und dieser Effekt noch verstärkt wird (Beispiel 4).

B. Problem 4 und Problem 5 werden aus demselben Grund deutlich besser gelöst als mit zu hoch siedenden Lösemitteln.

C. Selbst für Problem 2 hat es sich erwiesen (siehe Beispiel 5), daß das deutlich beschleunigte Trocknen der Pixel sich hier vorteilhaft auswirkt. Dabei ist es offensichtlich so, daß durch das schnelle Eindicken eine Entmischung praktisch vollständig vermieden werden kann. Dieser Befund war überraschend.

Die Probleme 2 bis 5 könnten natürlich prinzipiell auch durch das Verwenden von wirklich niedrig siedenden Lösemitteln (oder-gemischen) gelöst werden. Diese bereiten aber für Problem 1 technisch nicht lösbare Schwierigkeiten. Somit sind gerade Lösemittel im angegebenen Bereich eine optimale Lösung für die beiden Problembereiche.

Die Probleme 1 bis 5 in Kombination können nicht sinnvoll mit einem einzigen Lösemittel gelöst werden. Wird ein zu niedrig siedendes Lösemittel verwendet, ist Problem 1 nicht zu lösen, wird ein zu hoch siedendes Lösemittel verwendet, werden 3 bis 5 immer schwerer lösbar.

Die erfindungsgemäßen Lösemittelgemische haben sich daher als überraschend einfache und wirksame Verbesserungen erwiesen.

Die Siedepunktsgrenze von 200°C erscheint auf den ersten Blick etwas willkürlich, zieht aber eine technisch sinnvolle Grenze bei der vorliegenden Erfindung. Bei Lösemitteln die über dieser Grenze liegen (z. B. Tetralin, vgl. Beispiel 1, Cyclohexylbenzol, n-Pentylbenzol) werden vor allem die Probleme 3 und 4 (das Eindicken dauert zu lange) und schließlich (wenn man dieses Problem mit einem Gemisch behoben hat) das Problem 5 (das vollständige Entfernen der Lösemittel aus dem Film) technisch schwer behebbar.

Daß die eingesetzten Lösemittel einen Schmelzpunkt von 15°C oder weniger aufweisen sollen, ist dadurch zu belegen, daß die Lösungen bzw. Dispersionen unter Umständen (zwischen Herstellung und Einsatz) über Tage bis zu Monaten gelagert, eventuell auch transportiert werden müssen. Hier muß sichergestellt werden, daß die Lösungen bzw. Dispersionen auch als solche stabil bleiben und nicht bei Lagerung und/oder Transport ausfrieren oder sonstige nachteiligen Lager- und/oder Transporteffekte zu beobachten sind.

Die erfindungsgemäße Lösung bzw. Dispersion muß mindestens ein Lösemittel enthalten, daß einen Siedepunkt von mehr als 140°C aufweist. Siedepunkt soll in diesem Anmeldetext den Siedepunkt unter Normaldruck (1013 mbar) bedeuten. Diese Grenze ist zu setzen, da es sich technisch erwiesen hat, daß bei Verwendung von Lösemitteln mit niedrigeren Siedepunkten das Eintrocknen der Düsen innerhalb weniger Sekunden nach Beendigung des Druckvorganges stattfindet. Sobald dieser Wert bei etwa 10 Sekunden oder darüber ist, kann durch geeignete technische Hilfsmittel (Druckkopf fährt in Warteposition, Düsen werden mit Kappe mechanisch verschlossen) ein Austrocknen verhindert werden.

Somit erweist sich die Verwendung mindestens eines Lösemittels mit Siedepunkt zwischen 140 und 200°C als wichtig für die erfindungsgemäßen Effekte.

Bei der Verwendung von Lösemitteln mit benzylischen $CH_2$- bzw. CH-Gruppen zeigt die gebildete Lösung bzw. Dispersion eine äußerst geringe Stabilität und ist für die technische Massenproduktion ungeeignet. Insofern sind die in WO 00/59267 zum Teil empfohlen Lösemittel (z. B. Tetralin, Dodecylbenzol, Cumol, und weitere ähnliche Lösemittel) bei der Lösung der eingangs beschriebenen Probleme nicht hilfreich. So wurde beispielsweise gefunden (vgl. auch Beispiel 2), daß eine Tetralinlösung eines PPV-Derivats innerhalb weniger Wochen (trotz Lagerung unter Schutzgas und unter Lichtausschluß) eine deutliche Veränderung der Eigenschaften (Abnahme der Viskosität, Abbau des Molekulargewichts des Polymers, Verschlechterung der Device-Eigenschaften bei Präparierung von PLED-Displays) mit sich bringt. Ähnliche Ergebnisse wurden unter anderem auch mit Cumol, 2-Butylbenzol und n-Butylbenzol erhalten.

Die Verwendung / Mitverwendung von Lösemitteln, die derartige Gruppen in den Seitengruppen tragen, ist daher ungeeignet, da es zu einer deutlichen Verschlechterung der Eigenschaften führt.

Die Verwendung von Lösemitteln, die eine Vielzahl von aromatischen Methylgruppen bzw. mindestens eine tert-Butylgruppe aufweist, hat sich insofern als problematisch erwiesen, da sich hierin eine Vielzahl von polymeren Halbleitern nur als schlecht löslich erwies. Dies ist näher in Beispiel 3 aufgeführt.

Natürlich kann ein solcher Überblick und eine derartige Untersuchung nicht umfassend sein, der Trend ist aber deutlich sichtbar. Um die Ausführung der Erfindung nicht unnötig zu erschweren, sind erfindungsgemäß benzolische Lösemittel mit mehr als zwei Methylgruppen bzw. mindestens einer tert-Butylgruppe nicht erfindungsgemäß bzw. auszuschließen.

In dieser physikalisch-chemisch sinnvollen Ausführungsform werden einerseits die der Erfindung zugrundeliegenden Probleme gelöst und andererseits eine technisch sinnvolle Abgrenzung gegenüber den Lösungen gemäß dem oben zitierten Stand der Technik, respektive WO 00/59267, gesehen.

Für die erfindungsgemäßen Lösungen sind nun unter anderem folgende Lösemittel mit Siedepunkt zwischen 140 und 200°C geeignet. Hierbei handelt es sich insbesondere um substituierte und unsustituierte Xylolderivate, Di-C1-C2-Alkylformamide, substituierte und unsubstituierte Anisole, weitere Phenoletherderivate, substituierte Heterocyclen, wie substiutierte Pyridine, Pyrazinen, Pyrimidine, Pyrrolidinone, substituierte und unsubstituierte N,N-Di-C1-C2-Alkylaniline und weitere fluorierte oder chlorierte Aromaten.

Besonders bevorzugt sind die in der nachfolgenden Tabelle aufgeführten Lösemittel mit Siedepunkt zwischen 140 und 200°C

| | Lösemittel | CAS-Nummer | Siedepunkt [°C] | Schmelzpunkt [°C] | Sonstiges (z. B. Flammpunkt, Flp.) |
|---|---|---|---|---|---|
| 1 | o-Xylol | 95-47-6 | 144 | -24 | Flp.32°C |
| 2 | 2,6-Lutidin | 108-48-5 | 145 | -6 | Flp. 33°C |
| 3 | 2-Fluor-m-xylol | 443-88-9 | 147 | n. a. | Flp. 30°C |
| 4 | 3-Fluor-o-xylol | 443-82-3 | 150 | n. a. | Flp. 36°C |
| 5 | 2-Chlorbenzotrifluorid | 88-16-4 | 152 | -7 | Flp. 58°C |
| 6 | Dimethylformamid | 68-12-2 | 153 | -61 | Flp.57°C |
| 7 | 2-Chlor-6-fluortoluol | 443-83-4 | 154 | -27 | Flp. 46°C |
| 8 | 2-Fluoranisol | 321-28-8 | 154 | -39 | Flp. 60°C |
| 9 | Anisol | 100-66-3 | 154 | -37 | Flp. 51°C |
| 10 | 2,3-Dimethylpyrazin | 5910-89-4 | 156 | n. a. | Flp. 54°C |
| 11 | 4-Fluoranisol | 459-60-9 | 157 | -45 | Flp. 43°C |
| 12 | 3-Fluoranisol | 456-4.9-5 | 160 | -35 | Flp. 43°C |
| 13 | 3-Trifluormethylanisol | 454-80-0 | 160 | -65 | Flp. 48°C |
| 14 | 2-Methylanisol | 578-58-5 | 170 | -34 | Flp. 51°C |
| 15 | Phenetol | 103-73-1 | 170 | -30 | Flp.57°C |
| 16 | 4-Methylanisol | 104-93-8 | 174 | -32 | Flp. 53°C |
| 17 | 3-Methylanisol | 100-84-5 | 175 | -55 | Flp. 54°C |
| 18 | 4-Fluor-3-methylanisol | 2338-54-7 | 175 | n. a. | Flp. 62°C |
| 19 | 2-Fluorbenzonitril | 394-47-8 | ~180 | n. a. | Flp. 73°C |
| 20 | 4-Fluor-veratrol | 398-62-9 | ~180 | n. a. | n. a. |
| 21 | 2,6-Dimethylanisol | 1004-66-6 | 182 | n. a. | Flp. 67°C |
| 22 | 3-Fluorbenzonitril | 403-54-3 | 185 | -16 | Flp. 67°C |
| 23 | 2,5-Dimethylanisol | 1706-11-2 | 190 | ~5 | Flp. 66°C |
| 24 | 2,4-Dimethylanisol | 6738-23-4 | 191 | n. a. | Flp. 63°C |
| 25 | Benzonitril | 100-47-0 | 191 | -13 | Flp. 71 °C |
| 26 | 3,5-Dimethylanisol | 874-63-5 | 193 | n. a. | Flp. 65°C |
| 27 | N,N-Dimethylanilin | 121-69-7 | 194 | 2 | Flp.62°C |
| 28 | 1-Fluor-3,5-dimethoxybenzol | 52189-63-6 | ~195 | n. a. | n. a. |
| 29 | N-Methylpyrrolidinon | 872-50-4 | 199 | -24 | Flp. 86°C |

Die in der Tabelle aufgeführten Lösemittel können keinen Anspruch auf Vollständigkeit erheben. Die Bereitung einer erfindungsgemäßen Lösung oder Dispersion ist dem Fachmann natürlich ohne weiteres auch mit weiteren hier nicht explizit aufgeführten Lösemitteln im angegebenen Siedebereich ohne erfinderisches Zutun möglich.

Jedoch hat sich die Verwendung beispielsweise rein aliphatischer Lösemittel (häufig mangelnde Löslichkeit bzw. Dispergierbarkeit), Aldehyd- bzw. Keton-haltiger Lösemittel + nitrierten Aromaten, phosphorhaltigen Lösungsmitteln (mangelnde Stabilität der Lösungen bzw. Dispersionen) und von Styrolderivaten bzw. anderer reaktiver Olefine (Polymerisationsneigung der Lösemittel) als nicht vorteilhaft erwiesen.

Für die erfindungsgemäßen Lösungen sind eine Vielzahl von Lösemitteln mit Siedepunkt unter 140°C geeignet.

Bei den erfindungsgemäßen Lösemitteln mit Siedepunkt unter 140°C gilt wiederum die bereits bei Lösemittel mit Siedepunkt zwischen 140 und 200°C gemachte Einschränkungen (keine Aliphaten, Olefine, Aldehyde, Ketone, Nitro und PhosphorVerbindungen). Des weiteren ist ein zu niedriger Siedepunkt nicht förderlich, denn dies erschwert, trotz Verwendung der Lösemittelmischung, die technische Lösung des Problems 1.

Es ist deshalb bevorzugt, in den erfindungsgemäßen Lösungen bzw. Dispersionen nur Lösemittel mit einem Siedepunkt von wenigstens 100°C und unterhalb 140°C zu verwenden.

Eine mit dieser Bevorzugung schon praktisch umgangene weitere technische Einschränkung ist der Verzicht auf stark giftige bzw. nachgewiesen kanzerogene Lösemittel, was zum Beispiel für Chloroform (Siedepunkt ~61°C), Tetrachlormethan (Siedepunkt ~77°C) und Benzol (Siedepunkt ~80°C) zutrifft.

Für die erfindungsgemäßen Lösungen sind nun unter anderem folgende Lösemittel mit Siedepunkt-unter 140°C geeignet.

Hierbei handelt es sich insbesondere um fluorierte oder chlorierte Aromaten bzw. Heteroaromaten, wie Benzol-, Toluol-, Xylol- und Pyridinderivate, aber auch Ether- und cyclische Etherderivate.

Ganz besonders sind die In der folgenden Tabelle ausgewählten, Lösemittel mit Siedepunkt unter 140°C bevorzugt, die überraschend gute Löse- bzw. Dispergiereigenschaften für organische Halbleiter, vor allem polymere organische Halbleiter, gezeigt haben.

| | | Lösemittel | CAS-Nummer | Siedepunkt [°C] | Schmelzpunkt [°C] | Sonstiges (z. B. Flammpunkt, Flp.) |
|---|---|---|---|---|---|---|
| | 1 | 3-Fluor-benzotrifluorid | 401-80-9 | 102 | -81 | Flp.7°C |
| | 2 | Benzotrifluorid | 98-08-8 | 102 | -29 | Flp. 12°C |
| | 3 | Dioxan | 123-91-1 | 102 | 12 | Flp. 12°C |
| | 4 | Trifluormethoxybenzol | 456-55-3 | 102 | -50 | Flp. 12°C |
| | 5 | 4-Fluor-benzotrifluorid | 402-44-8 | 103 | -41 | Flp. 7°C |
| | 6 | 3-Fluor-pyridin | 372-47-4 | 108 | n.a. | Flp. 13°C |
| | 7 | Toluol | 108-88-3 | 111 | -93 | Flp. 4°C |
| | 8 | 2-Fluor-toluol | 95-52-3 | 113 | -62 | Flp. 12°C |
| | 9 | 2-Fluor-benzotrifluorid | 392-85-8 | 115 | -51 | Flp. 17°C |
| | 10 | 3-Fluor-toluol | 352-70-5 | 115 | -87 | Flp. 9°C |
| | 11 | Pyridin | 110-86-1 | 115 | -42 | Flp. 20°C |
| | 12 | 4-Fluor-toluol | 352-32-9 | 116 | -56 | Flp. 17°C |
| | 13 | 2,5-Difluor-toluol | 452-67-5 | 120 | -35 | Flp. 12°C |
| | 14 | 1-Chlor-2,4-difluor benzol | 1435-44-5 | 127 | -26 | Flp.32°C |
| | 15 | 2-Fluor-pyridin | 372-48-5 | 127 | n. a. | Flp. 28°C |
| | 15 | 3-Chlorfluorbenzol | 625-98-9 | 127 | n. a. | Flp. 20°C |
| | 15 | 1-Chlor-2,5-difluorbenzol | 2367-91-1 | 128 | -25 | Flp. 20°C |
| | 16 | 4-Chlorfluorbenzol | 352-33-0 | 130 | -27 | Flp. 29°C |
| | 17 | Chlorbenzol | 108-90-7 | 132 | -45 | Flp.23°C |
| | 18 | 2-Chlorfluorbenzol | 348-51-6 | 138 | -42 | Flp. 31°C |
| | 19 | p-Xylol | 106-42-3 | 138 | 12 | Flp. 25°C |
| | 20 | m-Xylol | 108-38-3 | 139 | -4.7 | Flp.25°C |

Auch die in dieser Tabelle aufgeführten Lösemittel sind natürlich nicht als Einschränkung zu verstehen, sondern nur sinnvoller technischer Hinweis. Es können natürlich auch noch weitere Lösemittel, die ansonsten günstige Eigenschaften (Löslichkeit, Siedepunkt, Mischbarkeit, um nur einige zu nennen) aufweisen, für die erfindungsgemäßen Lösungen und Dispersionen Verwendung finden.

Bevorzugt sind also erfindungsgemäße Lösungen und Dispersionen, enthaltend ein oder mehrere Lösemittel ausgewählt aus o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, 4-Fluoranisol, 3-Fluoranisol, 3-Trifluormethylanisol, 2-Methylanisol, Phenetol, 4-Methylanisol, 3-Methylanisol, 4-Fluor-3-methyl-anisol, 2-Fluorbenzonitril, 4-Fluor-veratrol, 2,6-Dimethylanisol, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol oder N-Methylpyrrolidinon.

Des weiteren bevorzugt sind ebenso erfindungsgemäße Lösungen und Dispersionen, enthaltend ein oder mehrere Lösemittel ausgewählt aus 3-Fluor-benzotrifluorid, Benzotrifluorid, Dioxan, Trifluormethoxybenzol, 4-Fluor-benzotrifluorid, 3-Fluor-pyridin, Toluol, 2-Fluor-toluol, 2-Fluor-benzotrifluorid, 3-Fluor-toluol, Pyridin, 4-Fluor-toluol, 2,5-Difluor-toluol, 1-Chlor-2,4-difluorbenzol, 2-Fluor-pyridin, 3-Chlorfluorbenzol, 1-Chlor-2,5-difluorbenzol, 4-Chlorfluorbenzol, Chlorbenzol, 2-Chlorfluorbenzol, p-Xylol oder m-Xylol.

Eine bevorzugte Ausführungsform der erfindungsgemäßen Lösungen und Dispersionen liegt dann vor, wenn diese beim Eintrocknen (Aufkonzentrieren) sehr schnell Eindicken und Gelieren.

Besonders bevorzugt ist dieser Effekt bei Lösungen polymerer organischer Halbleiter anzuwenden.

Sehr schnell bedeutet in diesem Zusammenhang, daß dies schneller als beim puren Folgen einfacher physikalischer Gesetzmäßigkeiten erfolgt. So besteht für Polymerlösungen häufig folgender Zusammenhang zwischen Viskosität η und Konzentration c:

$$\eta \sim c^{3.4}$$

Anschaulich bedeutet dies, daß bei Verdopplung der Konzentration die Viskosität sich ca. verzehnfacht. Ab einem gewissen Punkt geliert dann die Lösung, d. h. sie ist nicht mehr richtig fließfähig.

Sehr schnell bedeutet also, daß sich bei einer Verdopplung der Konzentration, wie sie beim Eintrocknen eines gedruckten Films passiert, die Viskosität um mehr als diesen Faktor 10 erhöht, bzw. zumindest schneller, als bei einem Standardverlauf bei einer Lösung in einem Lösemittel.

Dies kann überraschend bei den erfindungsgemäßen Lösungen in bevorzugter Ausführung gefunden werden. Bereitet man Mischungen aus mindestens zwei Lösemitteln, in denen der polymere organische Halbleiter löslich ist, müssen i. d. R. folgende Voraussetzungen gegeben sein, um diesen überproportionalen Anstieg zu erhalten:

• Die Viskosität der Lösung des Polymers im Lösemittel 1 (niedrigerer Siedepunkt) ist gleich oder geringer als die einer Lösung des Polymers in Lösemittel 2.

• Beim Aufkonzentrieren einer Mischung reichert sich nun Lösemittel 2 in der Mischung an. Dies bringt nun, neben dem Konzentrationseffekt noch den Übergang zu einer (von vorneherein) höher viskosen Lösung.

Vortett einer derartigen bevorzugten erfindungsgemäßen Lösung ist, daß damit die oben geschilderten Probleme 2 bis 5 in hervorragender Weise gelöst werden können.

Eine weitere bevorzugte Ausführungsform kann es dann darstellen, eine Lösung die mindestens drei Lösemittel enthält, zu verwenden. Dadurch kann das eben erläuterte "sehr schnelle" Eindicken noch verstärkt werden.

Ein weiterer Gegenstand der Erfindung ist somit eine erfindungsgemäße Lösung oder Dispersion, dadurch gekennzeichnet, daß mindestens drei verschiedene Lösemittel verwendet werden.

Hierbei hat es sich als besonders vorteilhaft erwiesen, drei Lösemittel mit unterschiedlichen Siedepunkten zu verwenden.

Vorteilhaft ist dabei, wenn ein Lösemittel A mit eher niedrigem Siedepunkt (100 - 150°C), ein weiteres Lösemittel B mit einem mittleren Siedepunkt (130 -180°C) und ein drittes Lösemittel C mit einem hohem Siedepunkt (170 bis unter 200°C) verwendet wird.

Hierbei sollte dann eine Lösung oder Dispersion gerade in dem letzteren Lösemittel sehr dick bzw. sogar gelartig sein. Dann findet beim Eindicken eine extrem schnelle Viskositätssteigerung statt.

Wie auch beim Einsatz von zwei Lösemitteln kann sich auch hier das (Volumen)verhältnis der Lösemittel in einem weiten Bereich bewegen.

A: 1 - 70 %, bevorzugt 10 - 70 %
B: 1 - 90 %, bevorzugt 10 - 70 %
C: 1 - 60%, bevorzugt 10 - 50 %

Die Gesamtprozentzahl der jeweiligen Lösemittelmischung ergibt natürlich immer 100%.

Bei Lösemittelmischungen mit drei oder mehr Lösemitteln kann es auch eine Variante sein, daß eines der Lösemittel nicht-organisch, bevorzugt Wasser, ist. Dieses weitere nicht-organische Lösemittel, bevorzugt Wasser, wird aber nur in geringen Mengen verwendet, Bei der Verwendung von Wasser kann die einfache Restfeuchte nicht-getrockneter Lösemittel bereits ausreichen, die Eigenschaften der Lösungen oder Dispersionen zu verändern.

Im vorliegenden Anmeldetext und auch in den im weiteren folgenden Beispielen wird meist auf die Zusammensetzung von bzw. die Verwendung erfindungsgemäßer Lösungen oder Dispersionen in bezug auf polymere Leuchtdioden und den entsprechenden Displays abgezielt. Trotz dieser Beschränkung der Beschreibung ist es für den Fachmann ohne weiteres erfinderisches Zutun möglich, entsprechende erfindungsgemäße Lösungen oder Dispersionen auch für die Verwendung in anderen Devices herzustellen und anzuwenden, z. B. für Organische Integrierte Schaltungen (O-ICs), in Organischen Feld-Effekt-Transistoren (OFETs), in Organischen Dünnfilmtransistoren (OTFTs), für Organische Solarzellen (O-SCs) oder auch Organische Laserdioden (O-Laser), um nur einige Anwendungen zu nennen.

Die vorliegende Erfindung wird durch die folgenden Beispiele näher erläutert, ohne sie darauf einschränken zu wollen. Der Fachmann kann aus der Beschreibung und den aufgeführten Beispielen ohne erfinderisches Zutun weitere erfindungsgemäße Lösungen oder Dispersionen bereiten und diese anwenden, um daraus Schichten zu erzeugen.

**Beispiel 1: Vergleichsbeispiel; Filmbildung und Deviceeigenschaften erzeugt mit Lösungen aus Tetralin.**

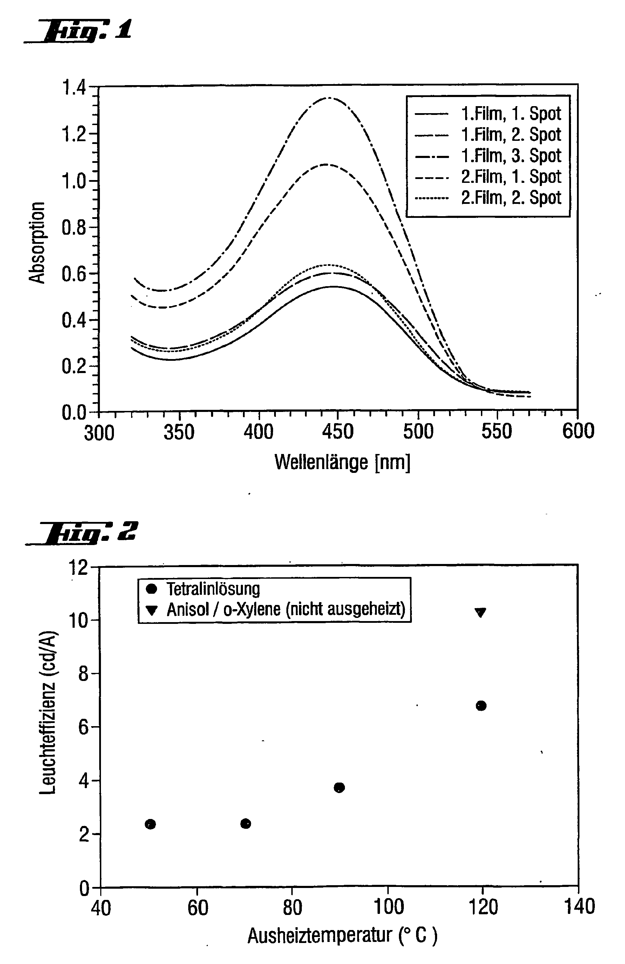

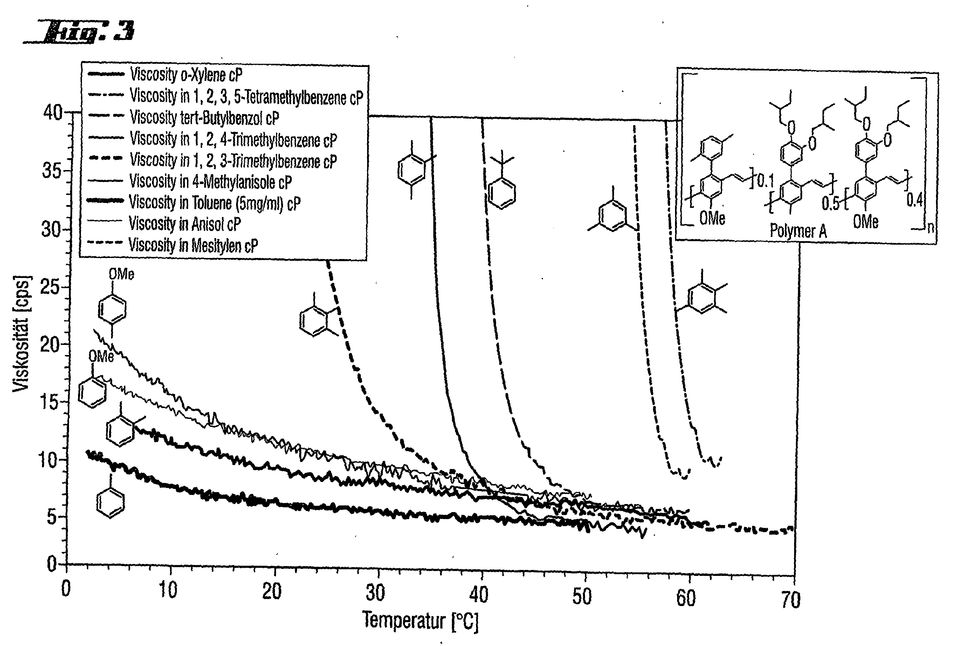

Die Verwendung nur eines Lösemittels, welches das Problem 1 (zu schnelles Eintrocken der Lösung im Druckkopf) lösen könnte, wie z. B. Tetralin, führt in der Filmbildung zum Auftreten der Probleme 3 bis 5. Absorptionsspektren erlauben über das Lambert-Beersche Gesetz ($E = \varepsilon\, c\, d$) die Messung von Schichtdicken. Figur 1 zeigt die Absorptionsspektren zweier Poly-arylen-vinylen-Filme (Polymer A, vgl. Tabelle 2), die auf identische Weise durch Spincoaten einer Tetralin-Lösung auf Glassubstrate von 3x3 cm hergestellt wurden. Die Schichtdicken variieren selbst auf einem Substrat um einen Faktor 2. Um homogene Filme zu erhalten, mußten die Filme 12 min auf dem Spincoater belassen und dann 10 min bei 120°C ausgeheizt werden. Diese langsame Trocknung führte in der Anwendung in Druckverfahren zu den schon angesprochenen Schwierigkeiten (Problem 4). Trotz der langen Trocknungszeit blieb der Restgehalt an Lösemittel so groß, daß die Effizienzen aus Tetralin hergestellter polymerer Leuchtdioden diejenigen aus Anisol/o-Xylol (v v = 1:1) nicht erreichten (s. Figur 2).

**Beispiel 2: Vergleichsbeispiele; Lagerstabilität von Polymerlösungen**

Lösung von Polymer A in Tetralin (Lösung 1)
Lösung von Polymer A in Cumol (Lösung 2)
Lösung von Polymer A in Anisol / o-Xylol (v : v = 1:1) (Lösung 3)
(Anmerkung: Polymer A; vgl. Tabelle 2 unter Beispiel 3)

Die Lösungen wurden alle parallel und gleich bereitet. Dazu wurden die festen Polymere (ca. 7.5 g/l) für ca. 30 h bei ca. 65°C unter Schutzgas aufgelöst, filtriert und unter Schutzgas in dichten Behältern gelagert. Die Lösungen wurden auf Ihre Eigenschaften direkt nach der Filtration (Lösungen 1, 2, 3) und 90 Tage (Lösungen 1a, 2a, 3a) später untersucht.

Die dabei erhaltenen Ergebnisse sind in Tabelle 1 zusammengefaßt.

Tabelle 1 Vergleich der Lagerstabilität verschiedener Polymerlösungen in unterschiedlichen Lösemitteln.

| Lösung | Viskosität [mPa*s] bei 40s⁻¹ | Molekulargewicht $M_w$, $M_n$ (/1000) [u] | Schichtdicke bei Filmpräperation [nm] | Elektroluminszenz Maximale Effizenz [Cd/A]; Spannung @ 100 Cd/m² [V] |
|---|---|---|---|---|
| 1 | 13.0 | 340,200 | 75 | 6.5 Cd/A; 3.5 V |
| 1 a | 8.9 | 210, 100 | 45 | 4.5 Cd/A; 4.2 V |
| 2 | 12.5 | 330,210 | 75 | 8.5 Cd/A; 3.3 V |
| 2a | 7.5 | 200,90 | 40 | 4.2 Cd/A; 3.9 V |
| 3 | 12.0 | 370,210 | 75 | 10.5 Cd/A; 3.2 V |
| 3a | 11.9 | 375,210 | 75 | 10.7 Cd/A; 3.4 V |

Die Lösungen in Tetralin (1, 1a) und Cumol (2, 2a) zeigten nur eine geringe Lagerstabilität. Es ist deutlich das jeweils die Anwendungseigenschaften sich dramatisch verschlechterten und ein direkter Abbau es Polymers gefunden wurde.

Es ist zu vermuten, daß dies auf geringe Spuren an Peroxiden in den jeweiligen Lösemitteln zurückzuführen ist. Die Lösemittel wurden zwar - fachmännisch - vorher (über LiAlH$_4$) getrocknet, von Peroxiden und Ketonen befreit und über eine Füllkörperkolonne destilliert und anschließend unter Schutzgas gelagert. GC/MS-Untersuchungen an Tetralin belegten jedoch, daß sowohl vor der Reinigung als auch nachher ca. ähnliche Mengen an Tetralon und Tetralol enthalten waren. Ähnliches ist leider auch für Tetralin-hydroperoxid zu vermuten.

Im Gegensatz dazu zeigte das erfindungsgemäße Lösemittelgemisch (Lösungen 3, 3a) keinerlei Anzeichen einer derartigen Degradation. Des weiteren waren auch noch primäre Anwendungseigenschaften (Effizienz und Spannung) in PLED Anwendung deutlich besser.

**Beispiel 3: Vergleichsbeispiel; Löslichkeit zweier konjugierter Polymere in verschiedenen Lösemitteln**

Es wurden- wie in Beispiel 2 - verschiedene Lösungen (Konzentration hier ca. 5 g/l) bereitet, und in diesem Fall dies Lösungskonsistenz direkt vermessen.

Die Ergebnisse sind in Tabelle 2 zusammengefaßt. Für Polymer A sind zur besseren Erläuterung des entsprechenden Verhaltens die einzelnen Gelkurven (Verlauf der Viskosität in Abhängigkeit der Temperatur) auch noch in Figur 3 abgebildet.

| Lösemittel | Lösungsverhalten Polymer A | Lösungsverhalten Polymer B |
|---|---|---|
| 1,2,3-Trimethylbenzol | Gelbildung (unterhalb 30°C) | *Gelbildung (bei ca. 35°C)* |
| 1,2,4-Trimethylbenzol | *Gelbildung (bei ca. 38°C)* | *Gelbildung (bei ca. 38°C)* |
| Mesitylen | Gelbildung (unterhalb 58°C) | Gelbildung (unterhalb 45°C) |
| tert-Butylbenzol | *Gelbildung (unterhalb 44°C)* | *Gelbildung (bei ca. 25°C)* |
| 1,2,3,5-Tetramethylbenzol | *Gelbildung (unterhalb 60°C)* | *Gelbildung (unterhalb 50°C)* |
| | | |
| Anisol | keine Gelbildung* | keine Gelbildung* |
| o-Xylol | keine Gelbildung* | keine Gelbildung* |
| Toluol | keine Gelbildung* | keine Gelbildung* |
| 4-Methylanisol | keine Gelbildung* | keine Gelbildung* |
| * keine Gelbildung bis 0°C zu beobachten. | | |

Tabelle 2

*Anmerkungen:*

*PolymerA: PPV-Derivat gemäß WO 99/24526, Polymer: Poly [(2-(3',4'-bis(2-methylpropyloxy)phenyl)-p-phenylenvinylen)co(2-(3',4'-bis(2-methylbutyloxy))phenyl)-5-methoxy-p-phenylenvinylen)co((2-(2,5-dimethylphenyl)-5-methoxy-p-phenylenvinylen]; $M_w$ ~ 1.000.000, $M_n$ ~ 310.000. Siehe auch Figur 3.*
*Polymer B: PF-Derivat gemäß WO 00/22026; Polymer gemäß Struktur P2 (Copolymer aus 9-(4-(3,7-dimethyloctyloxy)phenyl)-9-(2,5-dimethylphenyl)fluoren-2,7-bisboronsäurebisglycolester, 2,7-Dibrom-9-(2,5-dimethylphenyl)-9-(4-(3,7-dimethyloctyloxy)phenyl)fluoren und 1mol% 4,4'-Dibromtriphenylamin), allerdings mit deutlich erhöhtem Molekulargewicht: $M_w$ ~ 720.000, $M_n$ ~ 270.000.*

Es ist klar erkennbar (Figur 3), daß verschiedene Tri- und ein Tetramethylbenzol, ebenso wie tert-Butyl-benzol für die Polymere A und B schlecht als Lösemittel geeignet waren. Lösemittel, mit denen erfindungsgemäße Lösemittel-Mischungen hergestellt werden können, zeigten hingegen nicht diese negativen Effekte.

**Beispiel 4: Eintrocknen mehrerer erfindungsgemäßer Lösungen**

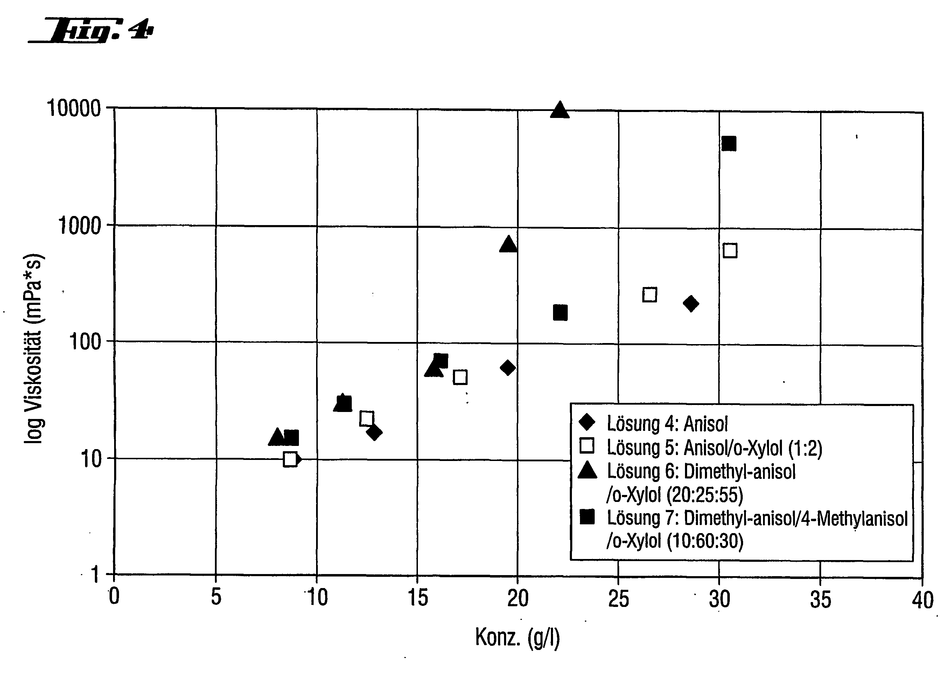

Es wurden mehrere Lösungen des Polymers A in verschiedenen Lösemitteln bzw. Lösemittelgemischen bereitet. Die Lösungsbereitung erfolgte analog zu den Angaben in Beispiel 2. Die Konzentration der Lösungen war dabei jeweils ca. 9 g/l. Die Lösungen wurden dabei so eingestellt, daß die Grundviskosität der Lösungen jeweils ca. gleich hoch war (ca. 8 bis 15 mPa*s, bei Scherraten von 40 s$^{-1}$). Von diesen Lösungen wurden dann jeweils Teile des Lösemittels abgezogen, die neue Konzentration (doppelt: einmal via UV/VIS, einmal rechnerisch via Menge abgezogenes Lösemittel) und die dazugehörige Viskosität wurden dann anschließend bestimmt. Die gefundenen Viskositätsverläufe sind in Figur 4 dargestellt.

Es wurden Lösungen in folgenden Lösemitteln bereitet:

Lösung 4: Anisol
Lösung 5: Anisol : o-Xylol (v : v = 1:2)
Lösung 6: 2,5-Dimethylanisol : Anisol : o-Xylol (v : v : v = 20:25:55)
Lösung 7: 2,5-Dimethylanisol : 4-Methylanisol : o-Xylol (v : v : v = 10:60:30)

Es ist klar zu erkennen (Figur 4), daß die erfindungsgemäße Lösung 5 und noch besser die erfindungsgemäßen Lösungen 6 und 7 im Vergleich zur Lösung 4, die nur ein Lösemittel enthielt, ein deutlich schnelleres Eindicken zeigte. Dies ist - wie in der Beschreibung geschildert - eine wichtige Eigenschaft, um die Probleme 3 bis 5 technisch zu lösen.

**Beispiel 5: Eintrocknung einer erfindungsgemäßen Lösung, enthaltend ein Polymerblend.**

Es wurde eine Lösung (Lösung 8) der o.g. Polymere B und A (Polymer B : Polymer A = 95 : 5 [m :m]) in dem Lösemittelgemisch 2,5-Dimethylanisol : Anisol : o-Xylol (v : v : v = 20:25:55) bereitet, mit der Gesamt-Polymer-Konzentration von 9 g/l. Diese Lösung wurde analog den Angaben in Beispiel 2 bereitet.
Es wurden nun zwei unterschiedliche Untersuchungen durchgeführt, um die Art des Eintrocknens dieses Polymerblends zu evaluieren:

- Zunächst wurden einfach Quarzgläser via Spin-Coating mit dem o. g. Blend beschichtet. Optisch sahen die dadurch erzeugten Filme jeweils klar und ohne eine erkennbare Strukturierung aus. Es wurden auch PL Spektren von jeweils 5 verschiedenen Punkten bei 4 verschiedenen Gläsern angefertigt. Diese zeigten jeweils dasselbe PL-Spektrum (jenes von Polymer A).
- Anschließend wurden kleine Tropfen der Lösung (5 -10 μl) auf Trägergläser aufgebracht, und deren Eintrocknen unter dem Polarisationsmikroskop verfolgt. Hierbei konnte keinerlei Phasenseparation festgestellt werden.

**Beispiel 6: Standardverfahren um PLEDs zu Testzwecken herzustellen:**

Die Herstellung von LEDs erfolgte nach dem im folgenden skizzierten allgemeinen Verfahren. Dieses mußte natürlich im Einzelfall auf die jeweiligen Gegebenheiten (z. B. Polymerviskosität und optimale Schichtdicke des Polymers im Device) angepaßt werden. In der Regel wurden Zweischichtsysteme, d. h. Substrat//ITO//leitfähiges Polymer//lich-temittierendes Polymer//Kathode hergestellt.

Nachdem man die ITO-beschichteten Substrate (z. B. Glasträger, PET-Folie, aber auch komplexe Substrate, Schaltkreise für eine Aktiv-Matrix-Ansteuerung enthaltend) auf die richtige Größe gebracht hat, werden sie - sofern dies nicht schon vorab geschehen ist - in mehreren Reinigungsschritten im Ultraschallbad gereinigt (z.B. Seifenlösung, Millipore-Wasser, Isopropanol). Zur Trocknung werden sie mit einer N$_2$-Pistole abgepustet und in einem Exsikkator gelagert. Vor der Beschichtung mit den Polymerlagen werden sie mit einem Ozon-Plasma-Gerät für ca. 20 Minuten behandelt.

Von dem jeweiligen Polymer wird die entsprechende Lösung oder Dispersion entweder mit einem Spin-coater aufgeschleudert oder auch durch Druckverfahren (z. B IJP) aufgebracht. Bevorzugt werden dabei die Verfahren auch so angewendet, daß die leitfähigen Polymere Schichtdicken im Bereich von 20 bis 200 nm und die emittierenden Polymere Schichtdicken im Bereich von 50 bis 100 nm aufweisen. Auf die Polymerfilme werden noch Elektroden aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode (z. B. Ca, Yb, Ba, oder auch Elektroden bestehend aus mehreren Schichten) als Kathode kontaktiert und die Device-Parameter bestimmt.
Beim Anlegen einer entsprechenden Spannung werden von der Anode aus Löcher, von der Kathode aus Elektronen in die Vorrichtung injiziert, die sich im Device treffen und einen angeregten Zustand erzeugen. Dieser kann unter Aussendung von Licht zerfallen. Dieses Licht wird durch die transparente Anode ausgestrahlt.

**Patentansprüche**

1. Lösungen und/oder Dispersionen organischer Halbleiter in einem Lösemittelgemisch von mindestens 2 verschiedenen organischen Lösemittel, **gekennzeichnet dadurch, daß**

    A. Jedes der Lösemittel für sich allein genommen einen Siedepunkt von weniger als 200°C aufweist und einen Schmelzpunkt von 15°C oder niedriger aufweist,
    B. mindestens eines der Lösemittel einen Siedepunkt zwischen mehr als 140 und weniger als 200°C aufweist
    C. die eingesetzten Lösemittel keine benzylischen $CH_2$- oder CH-Gruppen aufweisen,
    D. die eingesetzten Lösemittel keine Benzolderivate sind, die tert-Butylsubstituenten oder mehr als zwei Methylsubstituenten enthalten,
    E. des Unterschied der Siedepunkte der Lösemittel mehr als 10°C belögt.

2. Lösungen oder Dispersionen gemäß Anspruch 1, **dadurch gekennzeichnet, daß** es sich um Lösungen handelt.

3. Lösungen oder Dispersionen gemäß Anspruch 1, **dadurch gekennzeichnet, daß** es sich um Dispersionen handelt.

4. Lösungen oder Dispersionen gemäß Anspruch 1, **dadurch gekennzeichnet, daß** als organische Halbleiter polymere organische Halbleiter eingesetzt werden.

5. Lösungen oder Dispersionen gemäß Anspruch 4, **dadurch gekennzeichnet, daß** es sich um Lösungen handelt.

6. Lösungen gemäß Anspruch 5, **dadurch gekennzeichnet, daß** als polymerer organischer Halbleiter lösliche Poly-p-arylene-vinylene (PAVs) eingesetzt werden.

7. Lösungen gemäß Anspruch 5, **dadurch gekennzeichnet, daß** als polymerer organischer Halbleiter lösliche Polyfluorene (PFs) eingesetzt werden.

8. Lösungen gemäß Anspruch 5, **dadurch gekennzeichnet, daß** als polymerer organischer Halbleiter lösliche Polyspirobifluorene (PSFs) eingesetzt werden.

9. Lösungen gemäß Anspruch 5, **dadurch gekennzeichnet, daß** als polymerer organischer Halbleiter lösliche Poly-para-phenylene (PPPs) eingesetzt werden.

10. Lösungen gemäß Anspruch 5, **dadurch gekennzeichnet, daß** als polymerer organischer Halbleiter substituierte, lösliche Polythiophene (PTs) eingesetzt werden.

11. Lösungen gemäß Anspruch 5, **dadurch gekennzeichnet, daß** als polymerer organischer Halbleiter substituierte, lösliche Polypyridine (PPys) eingesetzt werden.

12. Lösungen gemäß Anspruch 5, **dadurch gekennzeichnet, daß** als polymerer organischer Halbleiter substituierte, lösliche Polypyrrole eingesetzt werden.

13. Lösungen gemäß Anspruch 5, **dadurch gekennzeichnet, daß** als polymerer organischer Halbleiter substituierte, lösliche Copolymere, die Struktureinheiten von mindestens zwei der in den Ansprüchen 6 bis 12 aufgeführten Polymerklassen enthalten, eingesetzt werden.

14. Lösungen gemäß Anspruch 5, **dadurch gekennzeichnet, daß** als polymerer organischer Halbleiter substituierte und unsubstituierte Poly-vinyl-carbazole oder substituierte und unsubstuierte Triarylaminpolymere eingesetzt werden.

15. Lösungen und Dispersionen gemäß einem oder mehreren der vorstehenden Ansprüche, **dadurch gekennzeichnet, daß** diese zwischen 0.25 und 10Gew% des organischen Halbleiters enthalten.

16. Lösungen und Dispersionen gemäß einem oder mehreren der vorstehenden Ansprüche, **dadurch gekennzeichnet, daß** diese Lösemittel mit unterschiedlichen Siedepunkten enthalten.

17. Lösungen oder Dispersionen gemäß einem oder mehreren der vorstehenden Ansprüche, **dadurch gekennzeich-**

**net, daß** diese nur Lösemittel mit einem Siedepunkt von wenigstens 100°C enthalten.

18. Lösungen oder Dispersionen gemäß einem oder mehreren der vorstehenden Ansprüche, **dadurch gekennzeichnet, daß** diese ein oder mehrere Lösemittel ausgewählt aus der Gruppe o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, 4-Fluoranisol, 3-Fluoranisol, 3-Trifluormethylanisol, 2-Methylanisol, Phenetol, 4-Methylanisol, 3-Methylanisol, 4-Fluor-3-methylanisol, 2-Fluorbenzonitril, 4-Fluor-veratrol, 2,6-Dimethylanisol, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol oder N-Methylpyrrolidinon enthalten.

19. Lösungen oder Dispersionen gemäß einem oder mehreren der vorstehenden Ansprüche, **dadurch gekennzeichnet, daß** diese ein oder mehrere Lösemittel ausgewählt aus der Gruppe 3-Fluor-benzotrifluorid, Benzotrrfluorid, Dioxan, Trifluormethoxybenzol, 4-Fluor-benzotrifluorid, 3-Fluor pyridin, Toluol, 2-Fluor-toluol, 2-Fluor-benzotrifluorid, 3-Fluor-toluol, Pyridin, 4-Fluor-toluol, 2,5-Difluor toluol, 1-Chlor-2,4-difluorbenzol, 2-Fluor-pyridin, 3-Chlorfluorbenzol, 1-Chlor-2,5-difluorbenzol, 4-Chlorfluorbenzol, Chlorbenzol, 2-Chlorfluorberizol, p-Xylol oder m-Xylol enthalten.

20. Lösungen oder Dispersionen gemäß einem oder mehreren der vorstehenden Ansprüche, **dadurch gekennzeichnet, daß** mindestens drei verschiedene Lösemittel enthalten.

21. Lösungen oder Dispersionen gemäß Anspruch 20, **dadurch gekennzeichnet, daß** die drei Lösemittel unterschiedliche Siedepunkte aufweisen.

22. Lösungen oder Dispersionen gemäß Anspruch 20 und 21, **dadurch gekennzeichnet, daß** ein erstes Lösemittel einem Siedepunkt zwischen 100 und 150°C, ein zweites Lösemittel mit einem Siedepunkt zwischen 130 und 180°C und ein drittes Lösemittel mit einem Siedepunkt zwischen 170 und weniger als 200°C, wobei die vorstehenden Lösemittel unterschiedlich sind, verwendet wird.

23. Verwendung der Lösungen und/oder Dispersionen gemäß einem oder mehreren der Ansprüche 1 bis 22 zum Erzeugen von Schichten organischer Halbleiter auf einem Substrat.

24. Verfahren zur Herstellung von organischen Halbleiterschichten wobei eine Lösung und/oder Dispersion gemäß einem der Ansprüche 1 bis 22 mittels eines Druckverfahrens verwendet wird.

25. Verfahren gemäß Anspruch 24, **dadurch gekennzeichnet, daß** das Druckverfahren ein Tintenstrahl-Druckverfahren (IJP) ist.

**Claims**

1. Solutions and/or dispersions of organic semiconductors in a solvent mixture of at least 2 different organic solvents, **characterised in that**

   A. each of the solvents on its own has a boiling point of less than 200°C and a melting point of 15°C or below,
   B. at least one of the solvents has a boiling point between greater than 140 and less than 200°C,
   C. the solvents employed do not contain benzylic $CH_2$ or CH groups,
   D. the solvents employed are not benzene derivatives containing tert-butyl substituents or more than two methyl substituents,
   E. the difference in the boiling points of the solvents is greater than 10°C.

2. Solutions or dispersions according to Claim 1, **characterised in that** they are solutions.

3. Solutions or dispersions according to Claim 1, **characterised in that** they are dispersions.

4. Solutions or dispersions according to Claim 1, **characterised in that** the organic semiconductors employed are polymeric organic semiconductors.

5. Solutions or dispersions according to Claim 4, **characterised in that** they are solutions.

6. Solutions according to Claim 5, **characterised in that** the polymeric organic semiconductors employed are soluble poly-p-arylene-vinylenes (PAVs).

7. Solutions according to Claim 5, **characterised in that** the polymeric organic semiconductors employed are soluble polyfluorenes (PFs).

8. Solutions according to Claim 5, **characterised in that** the polymeric organic semiconductors employed are soluble polyspirobifluorenes (PSFs).

9. Solutions according to Claim 5, **characterised in that** the polymeric organic semiconductors employed are soluble poly-para-phenylenes (PPPs).

10. Solutions according to Claim 5, **characterised in that** the polymeric organic semiconductors employed are substituted, soluble polythiophenes (PTs).

11. Solutions according to Claim 5, **characterised in that** the polymeric organic semiconductors employed are substituted, soluble polypyridines (PPys).

12. Solutions according to Claim 5, **characterised in that** the polymeric organic semiconductors employed are substituted, soluble polypyrroles.

13. Solutions according to Claim 5, **characterised in that** the polymeric organic semiconductors employed are substituted, soluble copolymers which contain structural units of at least two of the polymer classes mentioned in Claims 6 to 12

14. Solutions according to Claim 5, **characterised in that** the polymeric organic semiconductors employed are substituted and unsubstituted polyvinylcarbazole or substituted and unsubstituted triarylamine polymers.

15. Solutions and dispersions according to one or more of the preceding claims, **characterised in that** they comprise between 0.25 and 10% by weight of the organic semiconductor.

16. Solutions and dispersions according to one or more of the preceding claims, **characterised in that** they comprise solvents having different boiling points.

17. Solutions or dispersions according to one or more of the preceding claims, **characterised in that** they only comprise solvents having a boiling point of at least 100°C

18. Solutions or dispersions according to one or more of the preceding claims, **characterised in that** they comprise one or more solvents selected from the group o-xylene, 2,6-lutidine, 2-fluoro-m-xylene, 3-fluoro-o-xylene, 2-chlorobenzotrifluoride, dimethylformamide, 2-chloro-6-fluorotoluene, 2-fluoroanisole, anisole, 2,3-dimethylpyrazine, 4-fluoroanisole, 3-fluoroanisole, 3-trifluoromethylanisole, 2-methylanisole, phenetole, 4-methylanisole, 3-methylanisole, 4-fluoro-3-methylanisole, 2-fluorobenzonitrile, 4-fluoroveratrole, 2,6-dimethylanisole, 3-fluorobenzonitrile, 2,5-dimethylanisole, 2,4-dimethylanisole, benzonitrile, 3,5-dimethylanisole, N,N-dimethylaniline, 1-fluoro-3,5-dimethoxybenzene or N-methylpyrrolidinone.

19. Solutions or dispersions according to one or more of the preceding claims, **characterised in that** they comprise one or more solvents selected from the group 3-fluorobenzotrifluoride, benzotrifluoride, dioxane, trifluoromethoxybenzene, 4-fluorobenzotrifluoride, 3-fluoropyridine, toluene, 2-fluorotoluene, 2-fluorobenzotrifluoride, 3-fluorotoluene, pyridine, 4-fluorotoluene, 2,5-difluorotoluene, 1-chloro-2,4-difluorobenzene, 2-fluoropyridine, 3-chlorofluorobenzene, 1-chloro-2,5-difluorobenzene, 4-chlorofluorobenzene, chlorobenzene, 2-chlorofluorobenzene, p-xylene or m-xylene.

20. Solutions or dispersions according to one or more of the preceding claims, **characterised in that** they comprise at least three different solvents.

21. Solutions or dispersions according to Claim 20, **characterised in that** the three solvents have different boiling points.

22. Solutions or dispersions according to Claim 20 or 21, **characterised in that** a first solvent having a boiling point between 100 and 150°C, a second solvent having a boiling point between 130 and 180°C and a third solvent having a boiling point between 170 and less than 200°C, where the above solvents are different, are used.

23. Use of the solutions and/or dispersions according to one or more of Claims 1 to 22 for the production of layers of organic semiconductors on a substrate.

24. Process for the production of organic semiconductor layers in which a solution and/or dispersion according to one of Claims 1 to 22 is used by means of a printing process.

25. Process according to Claim 24, **characterised in that** the printing process is an ink-jet printing process (IJP).


**Revendications**

1. Solutions et/ou dispersions de semiconducteurs organiques dans un mélange de solvants d'au moins deux solvants organiques différents,
**caractérisées en ce que**

A. chacun des solvants tout seul présente un point d'ébullition inférieur à 200°C et un point de fusion de 15°C ou au-dessous,
B. au moins l'un des solvants présente un point d'ébullition supérieur à 140°C et inférieur à 200°C,
C. les solvants utilisés ne contiennent pas de groupe $CH_2$ ou CH benzylique,
D. les solvants utilisés ne sont pas des dérivés de benzène contenant des substituant tert-butyle ou plus de deux substituants méthyle ;
E. la différence en termes de point d'ébullition des deux solvants est supérieure à 10°C.

2. Solutions ou dispersions selon la revendication 1, **caractérisées en ce que** ce sont des solutions.

3. Solutions ou dispersions selon la revendication 1, **caractérisées en ce que** ce sont des dispersions.

4. Solutions ou dispersions selon la revendication 1, **caractérisées en ce que** les semiconducteurs organiques utilisés sont des semiconducteurs organiques polymériques.

5. Solutions ou dispersions selon la revendication 4, **caractérisées en ce que** ce sont des solutions.

6. Solutions selon la revendication 5, **caractérisées en ce que** les semiconducteurs organiques polymériques sont des poly-p-arylène-vinylènes (PAV) solubles.

7. Solutions selon la revendication 5, **caractérisées en ce que** les semiconducteurs organiques polymériques utilisés sont des polyfluorènes (PF) solubles.

8. Solutions selon la revendication 5, **caractérisées en ce que** les semiconducteurs organiques polymériques utilisés sont des polyspirobifluorènes (PSF) solubles.

9. Solutions selon la revendication 5, **caractérisées en ce que** les semiconducteurs organiques polymériques utilisés sont des poly-para-phénylènes (PPP) solubles.

10. Solutions selon la revendication 5, **caractérisées en ce que** les semiconducteurs organiques polymériques utilisés sont des polythiophènes (PT) solubles substitués.

11. Solutions selon la revendication 5, **caractérisées en ce que** les semiconducteurs organiques polymériques utilisés sont des polypyridines (PPy) solubles substitués.

12. Solutions selon la revendication 5, **caractérisées en ce que** les semiconducteurs organiques polymériques utilisés sont des polypyrroles solubles substitués.

13. Solutions selon la revendication 5, **caractérisées en ce que** les semiconducteurs organiques polymériques utilisés sont des copolymères solubles substitués qui contiennent des unités structurelles d'au moins deux des classes de polymères mentionnées selon les revendications 6 à 12.

14. Solutions selon la revendication 5, **caractérisées en ce que** les semiconducteurs organiques polymériques utilisés sont des polymères polyvinylcarbazole substitués et non substitués ou triarylamine substitués et non substitués.

15. Solutions et dispersions selon l'une quelconque des revendications précédentes, **caractérisées en ce qu'**elles comprennent entre 0,25% et 10% en poids du semiconducteur organique.

16. Solutions et dispersions selon une ou plusieurs des revendications précédentes, **caractérisées en ce qu'**elles comprennent des solvants présentant des points d'ébullition différents.

17. Solutions ou dispersions selon une ou plusieurs des revendications précédentes, **caractérisées en ce qu'**elles comprennent seulement des solvants présentant un point d'ébullition d'au moins 100°C.

18. Solutions ou dispersions selon une ou plusieurs des revendications précédentes, **caractérisées en ce qu'**elles comprennent un ou plusieurs solvants choisis parmi le groupe comprenant o-xylène, 2,6-lutidine, 2-fluoro-m-xylène, 3-fluoro-o-xylène, 2-chlorobenzotrifluorure, diméthylformamide, 2-chloro-6-fluorotoluène, 2-fluoroanisole, anisole, 2,3-diméthylpyrazine, 4-fluoroanisole, 3-fluoroanisole, 3-trifluorométhylanisole, 2-méthylanisole, phénétole, 4-méthylanisole, 3-méthylanisole, 4-fluoro-3-méthylanisole, 2-fluorobenzonitrile, 4-fluorovératrole, 2,6-diméthylanisole, 3-fluorobenzonitrile, 2,5-diméthylanisole, 2,4-diméthylanisole, benzonitrile, 3,5-diméthylanisole, N,N-diméthylaniline, 1-fluoro-3,5-diméthoxybenzène ou N-méthylpyrrolidinone.

19. Solutions ou dispersions selon une ou plusieurs des revendications précédentes, **caractérisées en ce qu'**elles comprennent un ou plusieurs solvants choisis parmi le groupe comprenant 3-fluorobenzotrifluorure, benzotrifluorure, dioxane, trifluorométhoxybenzéne, 4-fluorobenzotrifluorure, 3-fluoropyridine, toluène, 2-fluorotoluène, 2-fluorobenzotrifluorure, 3-fluorotoluène, pyridine, 4-fluorotoluène, 2,5-difluorotoluène, 1-chloro-2,4-difluorobenzène, 2-fluoropyridine, 3-chlorofluorobenzène, 1-chloro-2,5-difluorobenzène, 4-chlorofluorobenzène, chlorobenzène, 2-chlorofluorobenzène, p-xylène ou m-xylène.

20. Solutions ou dispersions selon une ou plusieurs des revendications précédentes, **caractérisées en ce qu'**elles comprennent au moins trois solvants différents.

21. Solutions ou dispersions selon la revendication 20, **caractérisées en ce que** les trois solvants présentent des points d'ébullition différents.

22. Solutions ou dispersions selon la revendication 20 ou 21, **caractérisées en ce qu'**un premier solvant présentant un point d'ébullition entre 100°C et 150°C, un second solvant présentant un point d'ébullition entre 130°C et 180°C et un troisième solvant présentant un point d'ébullition entre 170°C et moins que 200°C, où les solvants mentionnés ci-avant sont différents, sont utilisés.

23. Utilisation des solutions et/ou dispersions selon une ou plusieurs des revendications 1 à 22 pour la fabrication de couches en semiconducteurs organiques sur un substrat.

24. Procédé pour la fabrication de couches semiconductrices organiques où une solution et/ou une dispersion selon l'une des revendications 1 à 22 sont utilisées au moyen d'un processus d'impression;

25. Procédé selon la revendication 24, **caractérisé en ce que** le processus d'impression est un processus d'impression à jet d'encre (IJP).

## Fig. 1

Legend:
- 1.Film, 1. Spot
- 1.Film, 2. Spot
- 1.Film, 3. Spot
- 2.Film, 1. Spot
- 2.Film, 2. Spot

Y-axis: Absorption
X-axis: Wellenlänge [nm]

## Fig. 2

Legend:
- ● Tetralinlösung
- ▼ Anisol / o-Xylene (nicht ausgeheizt)

Y-axis: Leuchteffizienz (cd/A)
X-axis: Ausheiztemperatur (° C)

**Fig. 3**

Fig. 4

Legend:
- ◆ Lösung 4: Anisol
- ☐ Lösung 5: Anisol/o-Xylol (1:2)
- ◀ Lösung 6: Dimethyl-anisol /o-Xylol (20:25:55)
- ■ Lösung 7: Dimethyl-anisol/4-Methylanisol /o-Xylol (10:60:30)

X-axis: Konz. (g/l)
Y-axis: log Viskosität (mPa*s)